# EUROPEAN PATENT APPLICATION

(11) **EP 2 564 996 A1**
(43) Date of publication of application: **06.03.2013**
(21) Application number: 11007084.4
(22) Date of filing: 31.08.2011
(51) Int. Cl.: B26D 5/00, B26F 1/28, B23K 26/38, B23K 26/40, H01L 21/00

(54) **A method of generating a hole or recess or well in an electrically insulating or semiconducting substrate**

(71) Applicant: Asahi Glass Company, Limited, Chiyoda-ku Tokyo 100-8405 (JP)
(72) Inventor: Schmidt, Christian, 6390 Engelberg, Obwalden (CH); Dittmann, Leander, 1005 Lausanne, Vaud (CH); Chaize, Adrien, 2068 Hauterive, Neuchatel (CH); Hoyer, Svend, 1022 Chavannes-près-Renens, Vaud (CH)
(74) Representative: Engelhard, Markus

(57) **Abstract**

The present invention relates to a method of generating a hole or recess or well or array thereof in an electrically insulating or semiconducting substrate. The invention also relates to an array of holes or wells or recesses in a substrate generated by the method. The invention also relates to a device for performing the method according to the present invention.

## Description

The present invention relates to a method of generating a hole or recess or well or array thereof in an electrically insulating or semiconducting substrate. The invention also relates to an array of holes or wells or recesses in a substrate generated by the method. The invention also relates to a device for performing the method according to the present invention.

WO 2005/097439 and WO 2009/059786 disclose methods of generating structures in substrates using the application of voltages to a substrate. The holes of these earlier applications, when present in arrays, typically require large distances (typically > 1 mm) between adjacent holes to avoid flashovers during production of arrays without insulating layers. WO 2011/038788 and WO 2010/063462 disclose methods of generating structures in substrates using the application of voltages to a substrate which allow the fabrication of arrays of holes with small pitch (typically < 1 mm). These methods are limited in speed for producing multiple holes due to the necessary recharging of the high voltage capacitor to an energy required to open the hole. These patent applications also have limitations in terms of the quality and reliability with which the process can be performed.
Accordingly there is a need in the art to provide for improved methods allowing the generation of holes and dense arrays thereof in substrates as well as a significant improvement of quality and controllability of hole parameters.

It was therefore an object of the present invention to provide for a device and method for producing holes with a better controllability of the shape of the holes and the surface quality at and around the holes. It was also an object of the present invention to provide such a method which is faster and more energy efficient. It was also an object of the present invention to provide for such a method which is easy to perform and which can be adapted to mass production of such perforated substrates.

The objects of the present invention are solved by a method of generating a hole or recess or well or continuous line-like structure or arrays thereof in an electrically insulating or semiconducting substrate, comprising the steps:
a) providing a substrate which is electrically insulating or semiconducting at room temperature, placed between two electrodes,
b) melting a volume of material of said substrate by heating said volume using a heat source, said volume extending fully or partially from a first surface of said substrate to a second surface of said substrate, said second surface being opposite said first surface,
c) removing the molten volume of material resulting from step b) by applying a voltage of user-defined magnitude across said substrate using two electrodes connected to a user-controlled voltage source and placed at a distance from and on opposite sides of said substrate, thereby applying a defined amount of electrical energy to the substrate and dissipating said electrical energy from said substrate,
   wherein the rate of dissipating said applied electrical energy is controlled by at least one current and/or power modulating element, said at least one current and/or power modulating element being part of the electrical connection between said voltage source and said electrodes, wherein said current and/or power modulating element is a resistor, a capacitor or an inductor or any combination of the foregoing, with the proviso that, if there is only one current and/or power modulating element, it is not an ohmic resistor.

In one embodiment said method is performed using a device comprising
- a first electrode and a second electrode,
- a switch,
- optionally an AC voltage source,
- a DC voltage source,
- a timing and control unit,
- a means to hold a substrate, and
- a laser
said first electrode being a ground or reference electrode, said second electrode being a voltage electrode for applying a voltage to said substrate, said electrodes being located on opposite sides of said substrate, said second electrode being connected to said switch which switch is connected to said AC voltage source and said DC voltage source; said AC voltage source, said DC voltage source, and said switch being connected to said timing and control unit.

In one embodiment said at least one current and/or power modulating element is located in the electrical connection between said switch and said DC voltage source, or is located in the electrical connection between said second electrode and said switch, or is located in the electrical connection between said first electrode and ground, or is intrinsic part of said DC voltage source, or is part of said switch, or any combination of the foregoing if there is more than one current and/or power modulating element.

In one embodiment there is more than one current and/or power modulating element which is, independently, at each occurrence, selected from a resistor, capacitor and an inductor.

In one embodiment there is a combination of two current and power modulating elements, and said combination is a combination of a resistor and a capacitor, or is a combination of a resistor and an inductor, or is a combination of a capacitor and an inductor.

In one embodiment there is a combination of three or more current and/or power modulating elements, and said combination is a combination of zero, one or more resistor(s), zero, one or more capacitor(s) and zero, one or more inductor(s).

In one embodiment said heat source is a laser, preferably said laser of said device defined above, or a heating element or heating plate, connected to said timing and control unit and being capable of heating a substrate at a defined position, if such substrate is held by said means to hold a substrate.

In one embodiment said current and/or power modulating element, if it is a resistor, has a resistance in the range of from 0.01 Ohm to 1 MOhm, preferably 1 Ohm to 100 kOhm, more preferably 1 Ohm to 10 kOhm, and, if it is a capacitor, it has a capacitance in the range of from 0.1 pF to 100 nF, preferably 1 pF to 10 nF, more preferably 1 pF to 1 nF,
and, if it is an inductor, it has an inductance in the range of from 0.1 uH to 10 mH, preferably 1 uH to 1 mH, more preferably 1 uH to 500 uH.

In one embodiment, said current and/or power modulating element(s) is (are) used to define and/or control the shape and/or geometry of the hole or recess or well.

The objects of the present invention are also solved by a device for performing the method according to the present invention, said device being defined as above.

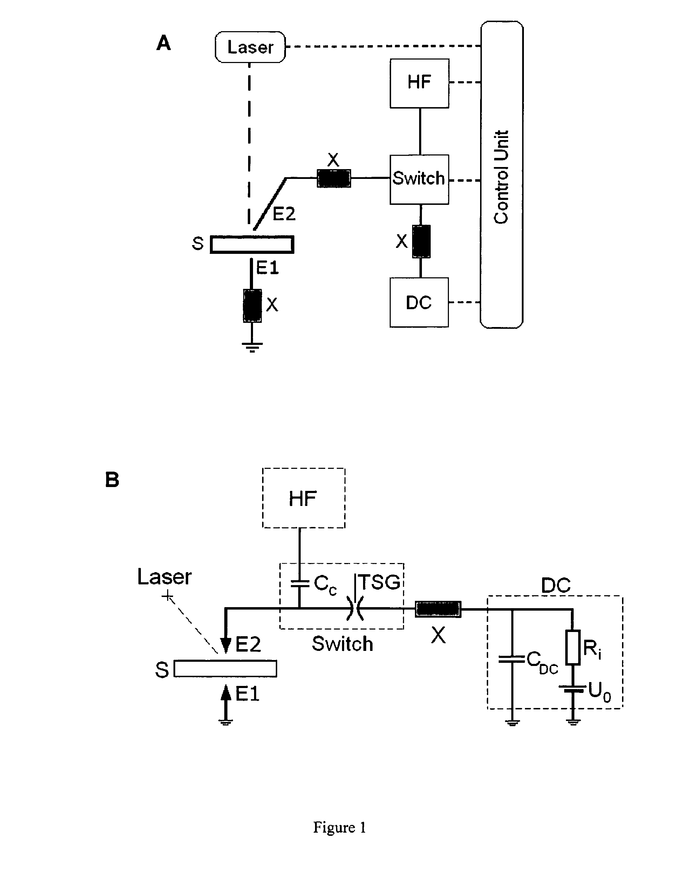

An embodiment of the basic setup used for generating a structure in a substrate is shown in Figure 1A. The substrate to be processed is placed between two electrodes and a volume of substrate material is molten by a heat source, typically a laser or a high frequency (HF) generator or a combination of such heat sources. The molten material is removed by applying a DC voltage pulse across the substrate using the two electrodes connected to a voltage source and placed at a distance from and on opposite sides of the substrate.

The term "AC voltage source" is meant to refer to a voltage source capable of generating an AC voltage, preferably at high frequency. The term "AC voltage source", as used herein, is used synonymously and interchangeably with expressions like "high frequency generator", "HF generator", and "HF HV source" (HF = high frequency; HV = high voltage).

Properties and design of the electrical circuit, including the high frequency generator if present, the high voltage DC source, switch, electrodes, electrical components and connectors, are important for a fast and energy efficient process, its controllability and the quality of the holes drilled. Because of intrinsic electrical properties of the components used (e.g. self inductance of wires, internal capacitance of inductors, impedance of connectors, etc.) and parasitic effects the entire circuit may be in a state which is not user defined or not well defined at all e.g. in terms of its impedance and resonance frequency. This becomes even more true for the short process times in the microsecond range or even below where such a short DC discharge excites the system similar to a high frequency AC input, because the properties and response of the electrical system are frequency dependent. The result of such not well adapted conditions are insufficient quality of holes and lack of reproducibility.

In order to ensure reliable process performance and results, the properties of the electrical circuit (as e.g. impedance, resonance frequency, current wave form, transfer function) must be adapted to the hole properties required and to the process parameters used. This can be achieved by a modification of the electrical circuit, in the simplest way e.g. by adding or changing resistive and reactive elements.

In one embodiment, adding a resistor R in series in the DC circuit (Fig. 1, with X=R) between the capacitor C_{DC} (charged to a high voltage U) and the substrate S will (1.) modulate the voltage drop Uₛ across the substrate, Uₛ=U/(1+R/Rₛ₎, where Rₛ is the (time dependent) electrical resistance of the substrate, (2.) limit the peak current through the substrate, I = U/(R+Rₛ), (3.) modulate the temporal behavior of the DC discharge upon changing its characteristic time constant τ_{R} = (R+Rₛ)C_{DC}.
A small R leading to a high current amplitude and a short discharge time typically results in more ejected material and a larger hole diameter. In general, with increasing R the discharge dampens more and more so that upon exceeding a certain limit (which depends on the substrate material and thickness) of R no open holes will be formed anymore because the electrical power dissipated in the substrate becomes too small to eject enough material. Instead, blind holes or wells can be produced in that way when only a fraction of the molten material is ejected. The resistor in the circuit transforms energy into heat which is lost for the actual hole drilling process and therefore reduces the efficiency of the process.

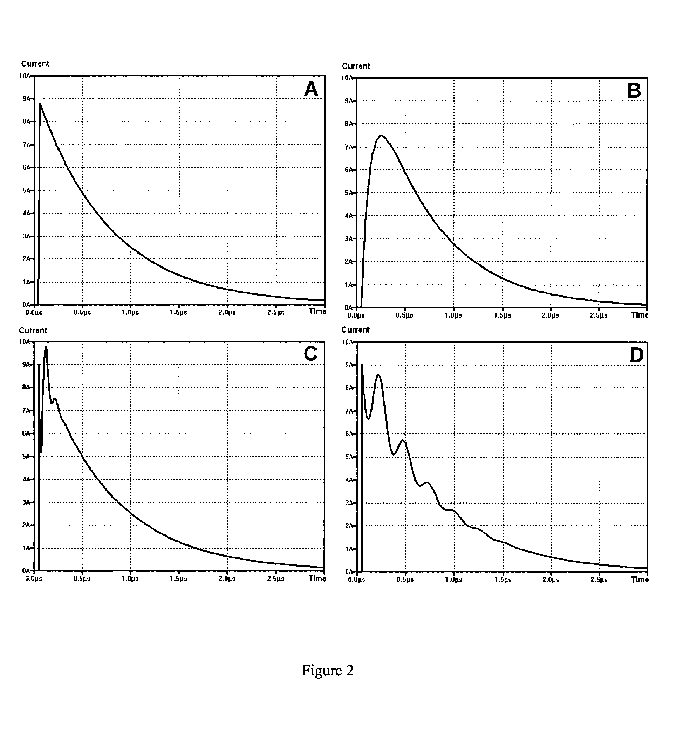

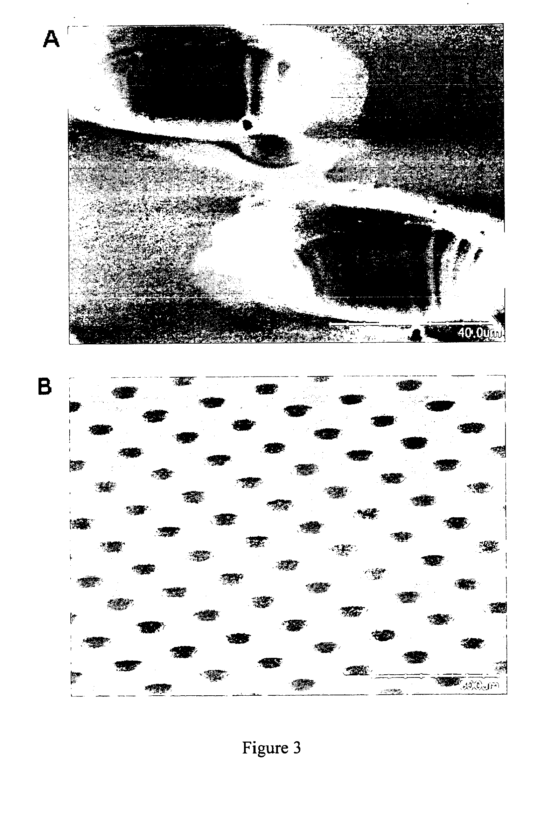

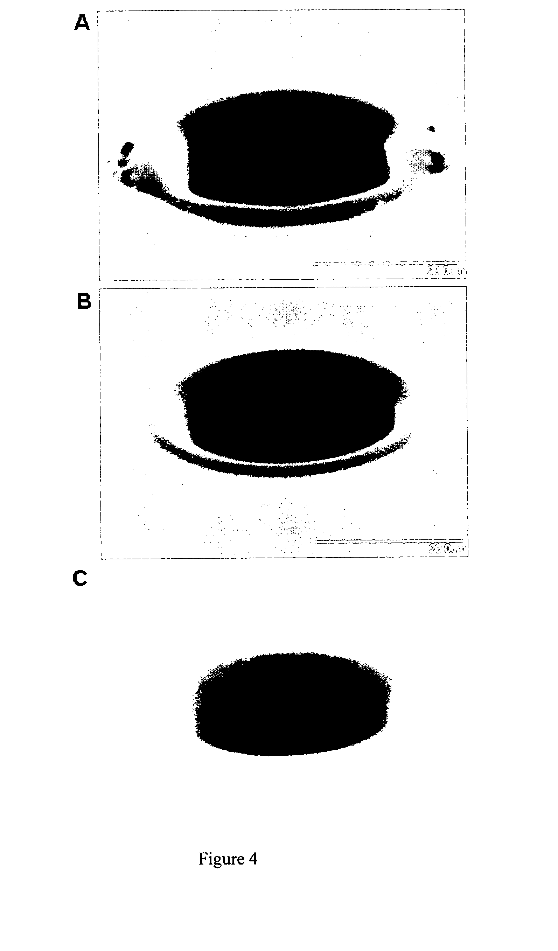

In one embodiment, instead of a resistor, a reactive component, e.g. an inductor L (Fig. 1, with X=L), can be used with the advantage that energy is not transformed into heat but temporarily stored in the magnetic field built up by the current flowing through the inductor and then fed back into the circuit. Therefore the entire process is more energy efficient and the process can be driven with a smaller input energy C_{DC}U²/2. This allows to reduce either the capacitance C_{DC} or the voltage U resulting in a shorter re-charging time of C_{DC}, and therefore leading to a faster repetition rate of sequential hole drilling. The inductance L introduces another time constant τ_{L} = L/Rₛ (in general a combination of resistor and inductor in series results in a time constant of τ_{L} = L/(R_{S}+R)) describing the exponential increase and decrease of the current flowing through L and through the substrate as well as the voltage drop across L and across the substrate. This leads (in contrast to an R only in the circuit) to a comparatively slow increase of current through the substrate at the beginning of the discharge (Fig. 2A,B). When the discharge current starts to decrease the energy temporarily stored in the magnetic field of the inductor will be released and counteract the current decrease leading to a comparatively slow decay of current with a time constant τ_{L} + τ_{R}. Holes drilled under such conditions are more structured inside the hole (Fig. 3A) and develop more material build-up on the surface around the hole (Fig. 4A). Size and shape of these structures can be tuned by tuning L, e.g. to obtain a defined structure around the hole in terms of a thicker filamentous rim (Fig. 4A) or a small rim (Fig. 4B). With a particularly adapted L holes were obtained with a very smooth inner surface and almost no material build-up on the surface around the hole entrance (Fig. 4C). When the inductance is much smaller than the electric circuit parasitic inductance, said parasitic inductance defines the process characteristics. As the parasitic inductance is highly variable, it may lead to uncontrolled process performance, and huge variations in hole properties and shapes.

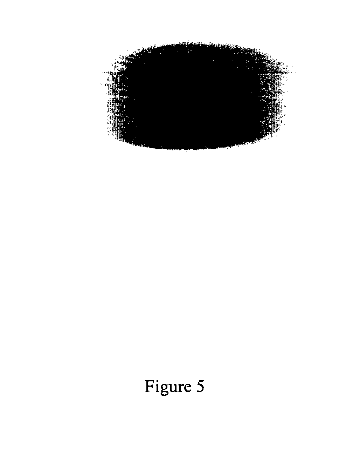

A combination of several reactive and/or resistive components allows a further modulation or tuning of the circuit. For instance an inductor L with a parallel capacitor C across placed in the circuit forms a parallel resonant subcircuit within the DC circuit with its resonance frequency ω = (LC)^{-½}. Upon discharging the high voltage capacitor C_{DC}, this subcircuit starts to oscillate and modulates the current flowing through the substrate. This AC oscillation on the current allowed a fine tuning of the hole quality, in particular to drill holes without any material build-up at the hole entrance (Fig. 5).

In general, any combination of an inductor, capacitor and resistor or even more than one of each component may be used to tune the process performance appropriately. Such components or combinations thereof may be placed at different positions in the DC circuit (Fig. 1B), or they may even be integral part of the DC source or part of the switch. For instance the switch (e.g. a triggered spark gap) itself may possess a certain defined impedance when it is closed, which might either be beneficial for the process or unfavorable so that it must be compensated for by e.g. an impedance matching. If, as a heat source, an AC voltage source operating at high frequency ("HF generator") with a certain inductance on the output is coupled to the system via a coupling capacitor C_{C} (Fig. 1B) it will also form a resonant subcircuit, which is not integral part of the DC circuit, but which is able to modulate the current through the DC circuit and the substrate (even when the HF power output is switched off, which is typically the case when the DC voltage is switched to the electrodes). Tuning C_{C} or the properties of the HF generator opens therefore another way to indirectly adapt the behavior of the DC circuit to the hole quality aimed for.

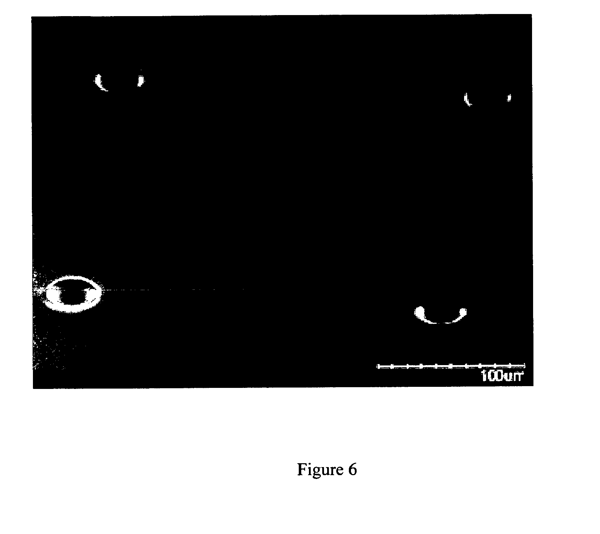

When the high voltage capacitor C_{DC} is discharged the peak current flowing through the circuit and the substrate can typically reach values of a few Amperes. Such high currents may cause additional effects as e.g. a possible magnetic saturation of the core. (typically a ferromagnetic material) of the inductor. When saturation is reached the inductance drops with further increasing current leading to a nonlinear operation. A defined nonlinearity can be exploited to control hole quality. If linear operation is preferred electrical elements with a saturation current above the maximum discharge current must be used or materials that do not saturate, as e.g. an air core. A hole quality obtained with a wire wound air core inductor is shown in Fig. 6 and reveals a clear difference to the result in Fig. 4C where a superflux ferrite core inductor was used, but with the same rated inductance value L = 5 uH.

The electrical performance can also be tuned by the design of the components used. For instance the type of wiring (diameter of wire, distance between windings, properties of insulation material) of an inductor may cause a significant self-resistance due to the frequency dependent skin effect and proximity effect, the latter may also cause the inductance to be dependent on the frequency. If the current flowing through the DC circuit is modulated with oscillations of frequencies higher than the self-resonance frequency of the inductor the inductor's impedance becomes capacitive-like for these higher frequencies which may cause an unwanted parasitic effect.

The inventors have surprisingly found that improved quality and process control of the method of hole drilling can be achieved using a current and/or power modulating element in the electrical circuit for performing such method. Such current and/or power modulating element may be a resistor, and inductor or a capacitor, as well as combinations of the foregoing. If, in the circuit for performing the method according to the present invention, the current and/or power modulating element is a single entity, i. e. if there is only one current and/or power modulating element, it is not an ohmic resistor.

Combinations of the foregoing, for example an inductor and a capacitor may also be used as current and/or power modulating element. Such a combination may be formed by an inductor with a parallel capacitor which is placed in the circuit and which forms a parallel resonant subcircuit having a resonance frequency. Such subcircuit starts to oscillate upon discharging the DC voltage source (which typically comprises a high voltage capacitor), and such oscillation modulates the current flowing through the substrate. Such oscillation can be used to fine-tune the hole quality.

In one embodiment said volume of step b) has a cylindrical shape or pillar-shape or conical shape, and wherein said volume extends from said first surface throughout said substrate to said second surface and has a length which is the thickness of said substrate. In another embodiment, said volume of step b) has a cylindrical shape or pillar shape or conical shape and does not extend fully from said first surface to said second surface, and wherein step c) results in a blind hole, recess or well. The term "cylindrical" shape is meant to also include those shapes where the cross section of such cylinder is not a perfect circle but an ellipse or other rounded shape.

In one embodiment said voltage applied in step c) is a constant or unipolar voltage.

In one embodiment said voltage is applied by applying a DC voltage in the range of from 1 kV to 250 kV. Such voltage may, e.g. be applied using a DC source to which the electrodes are connected.

In one embodiment said voltage is applied for a time period in the range of 1 ns to 10 s, preferably 10 ns to 8000 ms, more preferably 100 ns to 1000 ms.

In one embodiment said voltage is superimposed for all or part of step c) with an alternating (AC) voltage having a frequency > 10 kHz, preferably > 100 kHz, and more preferably ≥ MHz.

In one embodiment said heat source is selected from a laser or several lasers, a device being capable of providing an AC voltage at high frequency, such as a high frequency high voltage (HF HV) source or AC source, a Tesla transformer, a heating element, such as a heated filament, a heated electrode, a gas flame or a combination of such heat sources. A device being capable of providing an AC voltage at high frequency is a device which may cause dielectric losses in a substrate or may cause arc formation to and, possibly, through a substrate, if such an AC voltage at high frequency is applied to said substrate. A "high frequency high voltage source" is a voltage source that is providing a high AC voltage at high frequency. As used herein, the term "high voltage" is meant to refer to a voltage amplitude in the range of from 100 V to 100 kV. As used herein, the term "high frequency" is meant to refer to a frequency in the range of from 10 kHz to 1 GHz.

In one embodiment said heat source is a laser.

When the heat source is a laser it is preferred that said laser has a power of 1-10000 W, and, during step b) is operated at a power adapted to the material properties such as melting point and thickness, which may necessitate a reduction in laser power to e.g. ≥ 60%. In contrast to the methods of WO 2005/097439, it is preferred that said laser is operated such that significant amounts or even the entire volume of material is molten prior to initiation of step c).

In one embodiment said laser emits light which, upon irradiation on said substrate, is capable of penetrating said substrate material and which light, upon irradiation on said substrate, is not being fully absorbed or reflected at a surface of said substrate, but penetrates also in substrate regions underneath said surface.

In one embodiment two lasers beams are used for heating and melting. The two beams are pointed to the opposite sides of the substrate and volume to be molten and removed.

In one embodiment, said laser emits light which, upon irradiation on said substrate, is fully or nearly fully (>90%) absorbed at a substrate surface, and wherein said volume of material is heated by internal heat conduction.

In another embodiment, said laser emits light which, upon irradiation on said substrate, is not fully absorbed at a surface of said substrate so as to heat also within the substrate.

In yet another embodiment, said laser emits light which, upon irradiation on said substrate, is only weakly absorbed at a surface of said substrate, preferably < 10%, wherein this weak absorbance allows to heat the substrate homogeneously throughout its thickness.

In one embodiment said laser, when emitting light on a surface, has a focal spot having a diameter in the range of from 1 um - 15000 um, preferably 1 um - 10000 um, more preferably 2 um ― 500 um (1 um = 1 micrometer = 1 × 10⁻⁶m).

In one embodiment said laser, during step b), irradiates said volume of material of said substrate for a time period of 1 us to 10 s, preferably 1 us to 5000 ms, more preferably 1 us to 3000 ms, even more preferably 1 us to 1000 ms, and even more preferably 1 us to 300 ms.

In one embodiment, said heat source is a device being capable of providing a high AC voltage at high frequency, e.g. a high frequency high voltage source (HF-HV source), and step b) is performed by application of a high frequency high voltage (AC) across the substrate, said high frequency high voltage being preferably applied using the electrodes used in step c). In one embodiment, said high frequency high voltage has an amplitude in the range of from 100 V to 100 kV, preferably from 150 V to 50 kV, more preferably from 150 V to 25 kV, and said high frequency high voltage has a frequency in the range of from 10 kHz to 1 GHz, preferably from 50 kHz to 100 MHz, more preferably from 100 kHz to 50 MHz, and said high frequency high voltage is applied for a time period in the range of from 1 us to 5 s, preferably from 1 us to 1 s, more preferably from 50 us to 500 ms, even more preferably from 5 us to 100 ms. Melting of the substrate may, in such an embodiment, occur due to electric arc formation and/or dielectric losses in the substrate. In one embodiment, step b) comprises a first substep b1) and a second substep b2), wherein, in substep b2), said high frequency high voltage is applied, as defined above, across the substrate at a region of said substrate, wherein, in substep b1), said region is defined by pre-heating said region, e.g. by applying a laser pulse to said region. The laser pulse has a focus which defines the region. In one embodiment, said pre-heating occurs for a time period in the range of from 1 us to 100 ms, preferably from 1 us to 10 ms. In one embodiment, substeps b1) and b2) overlap by 1 us to 100 ms, preferably 1 us to 50 ms, and more preferably from 5 us to 10 ms. In one embodiment, step c) comprises a first substep c1) and a second substep c2), wherein, in substep c2), said DC voltage is applied, as defined above, to the substrate at a region of said substrate, and wherein in substep c1), said region is defined by applying a laser pulse to said region. In one embodiment, said laser pulse applied in substep c1) is applied at the same region that has previously been defined in substep b1), for example also by application of a laser pulse. In one embodiment, substep c1) is performed immediately after substep b1) or at a time interval from the end of substep b1) in the range of from 1 us to 5000 ms, preferably 1 us to 1000 ms, more preferably 1 us to 300 ms. In one embodiment, substep c) is initiated upon detection of an increase in current across the substrate, a decrease of voltage amplitude across the substrate, an increase of output current of the high frequency high voltage source, an increase of input current to the high frequency high voltage source, a decrease of output voltage of the high frequency high voltage source, or a change (decrease) of the high frequency electrical field emitted by the high frequency high voltage source. Such detection can, for example, be easily accomplished by measuring the appropriate parameters at the high frequency high voltage source. In one embodiment, substep c) is performed immediately after said detection or at a time interval from said detection in the range of from 1 us to 5000 ms, preferably 1 us to 1000 ms, more preferably 1 us to 300 ms. Timing of the various steps and substeps may be achieved by using a timing and control unit.

In one embodiment step c) is initiated at a time interval t after the beginning of step b) which time interval is in the range of from 0 ms to 10 s, preferably 1 us to 5000 ms, more preferably 1 us to 3000 ms.

It should be noted, however, that for substrates having a thickness ≥ 500 um, it is preferred that t ≠ 0 ms, and it is even more preferred, that step c) is initiated only after step b) is run for a significant amount of time such as > 10% of its total time - or even after step b) is finished, preferably after significant amounts or the entire volume of material is molten.

In one embodiment said removing of molten volume of material in step c) occurs by electrostatic forces applied through said voltage.

In one embodiment, said removing of molten material occurs or is supported by internal pressure buildup inside the substrate by field induced Joule heating.

In one embodiment heating and melting is achieved upon application of a high frequency (HF) high voltage (HV) across the substrate, preferably using the electrodes used as well for the application of the DC voltage that removes the material. The electric arc forming under these conditions can melt the respective volume.

In a related embodiment, frequency, voltage and duration of this HF voltage determine the diameter of the molten region. Suitable frequencies are between 10 kHz ― 1 GHz, preferably 50 kHz ― 100 MHz, more preferably between 100 kHz ― 50 MHz. Voltages are preferably between 100 V ― 100 kV, more preferably 150 V ― 50 kV, and more preferably between 150 V ― 25 kV. Application times are preferably between 1 us ― 1000 ms, more preferably 1 us ― 500 ms and more preferably between 5 us and 100 ms.

In one typical embodiment, the HF-HV discharge, i.e. the electric arc, is directed towards the region of interest on the substrate, by pre-heating and optionally generating a plasma in this region. Typically, a laser is used for this pre-heating, such as a laser (e.g. 10 ― 250 W CO₂ heating the spot for 0.001 ― 100 ms, preferably 0.001 ― 10 ms.

In one embodiment, a pre-heating laser pulse and the HF-HV application overlap by 0.001 — 100 ms, preferably 0.001 ― 50 ms, more preferably 0.005 ― 10 ms. This overlap provides for small pitches between adjacent holes, such as 0.07 mm for 40 um holes in 170 um thick alkali-free glass.

In one embodiment, the laser is employed to (1) guide the HF ― HV discharge/arc and (2) the DC HV discharge; this may be timed in such a way as to have two independent laser pulses or it may be combined in one single laser pulse overlapping the onset of the HF-HV discharge as well as the DC HV discharge.

In one embodiment, the method according to the present invention comprises:
a) providing a substrate which is electrically insulating or semiconducting at room temperature,
b1) pre-heating a region of said substrate where a hole is to be formed, using a heat-source, such as a laser, optionally melting a volume of material of said region using said heat source,
b2) optionally applying a high frequency high voltage to said region, thereby melting a volume of material of said region,
c1) optionally applying a laser pulse at said region, and
c2) applying a DC voltage to said region, thereby removing the molten volume of material from said substrate.

In one embodiment, steps b1), b2), c1) and c2) are performed with an overlap between them, with the proviso that b1) is initiated first and step c2) is initiated last.

In one embodiment, the onset of a melting through the entire substrate is detected by analysis of the HF generator properties, such as current consumption (e.g. a sudden increase in current), output current and/or voltage, frequency, phase relationships, or a change (decrease) of the high frequency electrical field emitted by the high frequency high voltage source. This signal is used to trigger the application of the DC HV (step c) or optionally to trigger first a laser pulse (step c1) and then the DC HV (step c2). Triggering may occur immediately after detection of a molten region extending through the entire substrate thickness or occur with a preset delay, which may be set between 0 ― 1000 ms, preferably 0 ― 100 ms.

A typical embodiment providing the means to apply a DC HV (DC high voltage) as well as a HF HV through a single pair of electrodes consists of a one electrode connected to ground or any other suitable voltage reference point and the other electrode connected to a switch that routes either the DC HV or HF HV (high frequency high voltage) or the DC HV superimposed by a HF HV to the electrodes. Working with high frequencies and high voltages makes such switches difficult to design. One possible embodiment consists of a voltage electrode connected to the HF-HV source directly or through a small (0.1 ― 10000 pF) capacitor to the electrode and the DC high voltage connected through a triggered spark gap (typically 100 V to 30 kV) in series to the electrode. Another possible embodiment consists of a voltage electrode connected to the HF-HV source directly or through a small (0.1 ― 10000 pF) capacitor to the electrode and the DC high voltage connected through a relay (e.g. >10 kV reed relay) and a spark gap (typically in the range 500 ― 25 000 V, preferred 1000 ― 10 000 V) in series connected to the electrode as well. The spark gap serves mostly the purpose to isolate and to mount the electrode avoiding parasitic discharges of the HF HV source to surrounding parts as well as discharges through the relay into the DC HV source.

In a typical embodiment used to avoid excessive deposition of material removed from the substrate on its surface, a gas stream is used to blow the expelled material away during hole formation. To avoid excessive cooling of the substrate and therefore crack formation, the gas stream can be heated up to several 100 °C, such as air heated to 100 ― 800 °C.

In one embodiment invented to avoid excessive mechanical tensions during hole formation, in particular during the formation of dense arrays of holes, the reference/ground electrode is either formed or surrounded by another heat source such as a heating filament heating the substrate to a temperature significantly above room temperature, preferably 50 ― 700 °C for glass, more preferably 100 ― 500 °C.

In one embodiment said substrate is made of an electrically insulating material selected from glass, quartz, diamond, alumina, sapphire, aluminum nitride, zirconia and spinel, or is made of an electrically semiconducting material selected from elemental silicon, including doped silicon and crystalline silicon, germanium, and compound semiconductors, such as gallium arsenide and indium phosphide.

In one embodiment the durations of said heating in step b) and of said applying an voltage in step c) are determined and user-controlled by a timer-relay or two independent timer-relays, each of said durations being controlled independently of each other, or both being controlled by a trigger device which triggers, i.e. turns off or modulates the heat source and the voltage, upon certain process conditions such as a specified substrate current or temperature, or a threshold substrate current or temperature being reached. In one embodiment the heat source is not fully turned off after hole or recess or well formation in step c), but wherein the heat source is reduced in its heating action so as to modulate the passive cooling behaviour of the substrate thereby controlling/preventing the formation of thermal stress inside the substrate.

In one embodiment, before, during and/or after performance of step c), a flow of gas which is heated to a temperature in the range of from 100°C to 800°C is directed at the substrate at the region where step c) is performed. Such temperature controlled flow of gas, on the one hand, serves to remove from the substrate surface the expelled material that is ejected during hole formation, and on the other hand, helps to avoid thermal stresses within the substrate. In one embodiment, one of the electrodes, such as the ground or reference electrode, is formed or surrounded by a secondary heat source, such as a heating filament, which secondary heat source heats and maintains the substrate at a temperature in the range of from 50°C to 900°C, preferably from 50°C to 700°C, and more preferably from 100°C to 500°C. In a preferred embodiment, such secondary heat source heats and maintains the substrate at a constant temperature in the above-mentioned ranges.

In one embodiment said voltage source has a source impedance from 0 to ≤ 100 MΩ, preferably <10 MOhm and even more preferably < 1000 kOhm.

In one embodiment said electrodes are connected to a capacitor having a capacitance from 1 ― 200000 pF, connected to said DC voltage source.

In one embodiment said substrate has a thickness of from 0.05 mm to 10 mm, preferably a uniform thickness of from 0.05 mm to 7 mm.

A "thick" substrate, as used herein, is a substrate having a, preferably uniform, thickness of ≥ 150 um.

In one embodiment each of said electrodes are placed at a distance of from 0.1 mm to 25 mm from said substrate.

In one embodiment, during steps b) and/or c), or after step c), said substrate is moved relative to said electrodes and said heat source, e.g. laser, preferably by a defined distance. This allows to extend the hole/recess/well structures such as to e.g. produce lines within the substrate and also allows to weaken or even cut the substrate. It also allows the formation of arrays. Such relative movement may produce a continuous line-like structure in the substrate. As used herein, the term a "continuous line-like structure" may refer to a line-like recess structure, such as a channel along the surface of the substrate, or such term may also refer to a cut within said substrate. This depends to a large extent on the depth of heating/melting during step b).

In one embodiment, said substrate is moved, preferably by a defined distance, relative to said electrodes and said heat source, e.g. laser, after a hole is formed, that is after step c). This is particularly useful for the production of arrays of holes or recesses or blind holes.

In one embodiment, said substrate is moved, preferably by a defined distance, relative to said electrodes and said heat source, e.g. laser, during hole formation, that is during step b) and step c). This is particularly useful for a fast process, i.e. a short repetition time of holed drilling within an array.

Movement of the substrate relative to the electrodes and the heat source may thus also be used to produce arrays of holes. In this instance steps b) and c) are repeated for as many times as holes are to be formed. In this embodiment, after step c), the substrate is moved by a defined distance, and steps b) and c) are repeated again, to generate the next hole or recess or well or blind hole. If steps b) and c) are repeated n times, and the substrate is also moved n times, by a defined distance, this will produce an array of n + 1 holes. Depending on the direction of movement, one-dimensional or two-dimensional arrays can be formed.

The objects of the present invention are also solved by a hole or recess or well or line-like structure in a substrate, generated by the method according to the present invention.

The objects of the present invention are also solved by an array of holes or recesses or wells or continuous line-like structures in a substrate, generated by the method according to the present invention, wherein said holes or recesses or wells have a distance between them which is < 3 mm, preferably < 1.2 mm, more preferably < 500 um, even more preferably < 300 um, and even more preferably < 100 um. Using the method according to the present invention, it has become feasible and possible to generate such arrays at extremely high speed, with the average duration for formation of a single hole and moving to the next position to be in the range of 0.1 ms to ca. 10 ms. The pitch, i.e. the distance between the holes in such arrays, can be made surprisingly small without the risk of having electric arc formation to occur through already formed holes. Using the method according to the present invention, the fabrication of arrays of several thousands to hundred thousands of holes has thus become possible.

The objects of the present invention are also solved by a device for performing the method according to the present invention, said device comprising a first electrode and a second electrode, a switch, a high frequency high voltage source, a DC source, a timing and control unit, and a means to hold a substrate, said first electrode being a ground or reference electrode, said second electrode being a voltage electrode for applying a voltage to said substrate, said electrodes being located on opposite sides of said means to hold a substrate, said second electrode being connected to said switch which switch is connected to said high frequency high voltage source and said DC source, said high frequency high voltage source, said DC source, said switch and said first electrode being connected to said timing and control unit.

In one embodiment, said switch routes DC voltage or DC voltage and high frequency AC voltage to said electrodes and comprises a connection for said second electrode to said high frequency high voltage source, either directly or through a capacitor, and comprises a connection for said second electrode to said DC source through a triggered spark gap, or through a relay and a spark gap being connected in series .

In one embodiment, the device according to the present invention additionally comprises a heat source, preferably a laser or a heating filament or heating plate, connected to said timing and control unit and being capable of heating a substrate at a defined position, if such substrate is held by said means to hold a substrate.

In one embodiment, the device according to the present invention additionally comprises a means to direct a heated gas flow to a substrate, if present.

In one embodiment, said reference electrode is surrounded by or forms a further heat source, such as a heating filament, which heats the entire substrate or parts of it, if present, to a defined temperature or defined-temperature range, wherein such further heat source, preferably, has a heating power supply, and is connected to said timing and control unit, preferably through said heating power supply. In one embodiment, such further heat source is dimensioned such that it heats a substrate area in the range of from 1 mm² to 1000 mm². It may, in another embodiment, be dimensioned such that it heats the entire substrate. The overall purpose of such further heat source is to prevent the development of thermal stresses in the substrate. A person skilled in the art knows how to design and dimension e.g. heating filaments or heating plates to heat a defined area of the substrate.

As used herein, the term "a volume of material of said substrate" refers to a bulk mass of materials of said substrate. In the context of the present invention, it should be noted that such volume has a length which corresponds to the thickness of the substrate. In preferred embodiments, such volume has a pillar-shape or a cylindrical shape or conical shape and extends from one major surface of this substrate to the other major surface of the substrate located opposite.

In another embodiment, said volume does not extend throughout the substrate, and such volume may also have a cylindrical or conical or pillar shape. The resulting structure after removal of material will be a well or recess or blind hole.

The inventors have surprisingly found that it is possibly to generate holes or recesses or wells (several um to mm-scale) in a dielectric substrate, such as glass, quartz or silicon. If one melts a region of the substrate, including the surfaces of the substrate, but also the bulk material underneath the surfaces, this molten material can be fully removed by the application of a voltage. The heating can extend throughout the entire thickness of substrate and includes also the interior of a substrate and therefore melts the substrate at a given position throughout the substrate. The heating may also only partially extend within the substrate, in which case, after removal of said material, a well or recess or blind hole is formed.

The inventors have surprisingly found that the generation of holes/recesses on the scale of several um to several millimeters as well as the generation of arrays of such holes/recesses can be achieved by using a heat source, e.g. a laser and/or HF HV induced current flow, and the subsequent application of a voltage. A person skilled in the art knows which laser to choose, in terms of its power and type, given a particular substrate material. For example, with glass as a substrate, a CO₂ laser having a power of 25 W and being focussed to a ca. 10― 500 um spot has proved useful, with other powers also being possible (1W-10000W). Other heating means are, of course, also possible, provided the heat is allowed to penetrate into the substrate, either by direct heating from the heat source or by heat conduction inside the substrate, e.g. if the heating power is mostly absorbed on the substrate surface such as is the case with a CO₂ laser beam in glass.

In particular for thick substrates, where a direct heating of the entire volume to remove is not possible, using a laser for through melting appears disadvantageous and other means have to be chosen. The inventors found that a highly efficient heating and melting of small volumes is achieved upon application of a high frequency (e.g. 100 kHz ― 50 MHz) high voltage (e.g. 100 - 20 000 V), preferably between the electrodes otherwise used for the application of the DC HV. Application of this high frequency AC voltage leads to electric arc formation, where the substrate in between acts as the dielectric of a capacitor. The high temperature of the electric arc leads to local melting of the substrate. As the molten material presents only a small electric resistance, the interface between the molten and the still colder substrate material a significant power dissipation occurs at this interface, leading to a quick penetration of the electric arc/molten material into the sample. Furthermore the high frequency and high amplitude of the AC voltage leads directly to dielectric losses and therefore an energy dissipation inside the substrate and thus to a temperature increase. The dielectric loss typically increases with increasing temperature so that a very quick homogeneous through-heating though the thickness of the substrate is possible without relying on heat conduction. Even substrates as thick as 4 mm glass can be easily molten through within less than 2 sec. The absence of the need of heat conduction, as for many systems laser ― sample material required for through heating, enables this high efficiency.

The molten material is then expelled by application of a DC HV. In one embodiment, heating is therefore achieved by application of a HF voltage, followed with or without overlap by the DC voltage. This can, for example, be achieved by connecting a DC high voltage source and a high frequency Tesla transformer to the electrode using a suitable circuit or switch. Other possible heating means include a heating element, such as a laser, a heated filament, a heated electrode, a gas flame.

In accordance with the present invention, a volume of material, as defined further above, is melted using appropriate heating means, and is thereafter removed from the substrate by the application of a DC high voltage. It is important that the application of voltage occurs if an appropriate volume of material of the substrate is molten. "Appropriate" may mean that the volume extends throughout the substrate from one surface to the opposite surface, or it may only be that the volume extends within the substrate from one surface, but does not reach the opposite surface. Hence, depending on the thickness of the substrate, heating may take a time period in the range of from 0 ms to 10 s. Without wishing to be bound by any theory, it is presently believed that the subsequent removal of the molten volume of material occurs by electrostatic forces and pressure buildup inside the substrate to which the voltage seems to significantly contribute, possibly caused by Joule heating.

In terms of the dimensions of the hole that is ultimately generated using the method according to the present invention, this is determined both by the heat source, that is typically laser and/or HF HV source as well as the applied voltage. With respect to the laser, it is more specifically the spot size of the laser as well as the application time which determines the hole size. In terms of the applied voltage, it is more specifically the voltage magnitude and application time of such voltage, which determines the size of the hole. The application time of the voltage either refers to the width of a single discharge which can be tuned by tuning the electrical properties (as e.g. impedance) of the DC circuit. Or it refers to the time the switch is closed so as to route electrical energy from the DC source to the substrate. In the latter case multiple discharges can occur with repetition rate and voltage and current amplitudes defined by the properties of the DC source (as e.g. charging current of the capacitance C_{DC}). Additionally, the source impedance of the voltage source effects the hole size as well. If one increases the application time of the voltage, a saturation is reached in the sense that beyond a certain application time, for a given material and a given voltage, the hole size does not increase anymore. This is most likely to be due to the fact that, after a certain voltage application time, all the molten material has already been removed. With glass substrates in the range of approximately 100 um to 3 mm thickness, such saturation behavior typically occurs after application of a voltage for several ten ms to several hundred ms.

However, under typical conditions where the DC HV source (= DC source) provides always sufficient energy to expel all molten material from the process region, the most significant effect on the hole diameter comes from the local heat source and the area that is molten by this source. Therefore, time and magnitude of the laser and/or HF HV application determine mostly the hole diameter.

It should be noted that in some embodiments, the substrate may additionally also have an additional insulating layer attached which is heated first, and substrate heating occurs indirectly via the insulating layer.

Application of a voltage occurs by two electrodes placed on opposite sides of the substrate, which electrodes, in one embodiment, are connected to a capacitor which in turn is charged by a voltage source. The source impedance can be defined using an ohmic resistor R. As outlined further above, also the source impedance may have an influence on the hole size, in the sense that the hole diameter is indirectly proportional to the source impedance given a specific application time interval. For consistent results it has been shown advantageous to provide sufficient electrical energy (C_{DC}U²/2 and Integral (U∗I)dt)to expel all molten material and define the hole diameter by the preceding heating step.

The duration of step b), i.e. heating/melting step can be determined and controlled using a timer-relay/switch or timing and control unit. Likewise, the duration of the application of a voltage can also be user-controlled using a timer-relay/switch or timing and control unit. Both may also be modulated, such as turned off, with and without delay, upon a trigger event generated e.g. once a certain trans-substrate current or substrate temperature is reached. The time after the hole formation may be characterized by using a lower(ing) laser/heating power so as to modulate the cooling process to e.g. avoid thermally induced tensions inside the substrate.

Furthermore, reference is made to the figures, wherein the figures show the following:

**Figure 1 (A)** Gives an example of a basic experimental setup. A high voltage DC source, and optionally a high frequency source, HF, generating an AC voltage having a high frequency, are connected via a switch to the second electrode E2, a substrate S being placed between this second electrode and a first electrode E1 serving as a reference or ground electrode. The substrate is locally heated by focussed laser radiation and optionally also by the HF applied across the substrate. Upon melting of the substrate material a DC voltage pulse is applied between the electrodes by activating the fast switch between the DC source and the electrode driving the molten material out of the substrate. The process is modulated and tuned by one or more current and/or power modulating elements X which may be a resistor or an inductor or a combination thereof or a combination of resistor, inductor and capacitor. Shown are possible positions of X in the DC circuit, i.e. the circuit extending from the DC source over the switch to the electrode through the substrate. Laser, Switch, HF generator and DC source are controlled by a Control Unit. **(B)** Shows an example of a possible realization of the DC circuit. The DC source consists of a capacitor C_{DC} charged by high voltage source U₀ with internal DC impedance Ri. The switch contains a triggered spark gap TSG and a coupling capacitor C_{C} for the high frequency HF.

**Figure 2** Shows current-time-graphs of the trans-substrate current during a DC discharge as numerically obtained using LTSpice for different conditions. C_{DC} = 1 nF, U = 5 kV, substrate resistance R_{S} = 500 Ohm. **(A)** R = 10 Ohm, for experimental result with similar conditions see Fig. 4C. **(B)** L = 40 uH, for experimental result with similar conditions see Fig. 4 A. **(C)** L = 5 uH and 50 pF in parallel, for experimental result with similar conditions see Fig. 5. **(D)** L = 5 uH and 330 pF in parallel.

**Figure 3 (A)** Shows the inner structure of holes obtained with L = 17 uH, compared to holes produced with R = 10 Ohm in **(B)** and otherwise the same parameters U = 4.5 kV, C_{DC} = 5.6 nF.

**Figure 4** Shows how the shape of the hole entrance can be defined upon varying the inductance value in the DC circuit. The material was a 170 um thick glass, the process parameters were U = 5 kV, C_{DC} = 0.9 nF and **(A)** L = 40 uH resulting in a very pronounced but not symmetrical rim of material around the hole, **(B)** L = 15 uH giving reproducible and very defined homogeneous rims, **(C)** L = 5 uH where only a very tiny rim was produced. A further reduction of L led to large variations in results presumably due to not controlled parasitic inductances becoming more significant.

**Figure 5** A hole in a 170 um thick glass without any material build-up on the surface around the hole. This result was achieved by fine tuning the electrical circuit, in this particular case a capacitor of C = 50 pF was added in parallel to the L = 5 uH (as used in Fig 4C) to modulate the current wave form. U = 5 kV, C_{DC} = 0.9 nF.

**Figure 6** Shows the difference of hole quality obtained by an axially wound inductor with air core of L = 5 uH where a significant amount of material is deposited around the hole in comparison to Fig. 4C where the L = 5 uH inductor was of SMD packaged type with a WE-Superflux core.

The features of the present invention disclosed in the specification, the claims and/or in the accompanying drawings, may, both separately, and in any combination thereof, be material for realising the invention in various forms thereof.

## Claims

1. A method of generating a hole or recess or well or continuous line-like structure or arrays thereof in an electrically insulating or semiconducting substrate, comprising the steps:
a) providing a substrate which is electrically insulating or semiconducting at room temperature, placed between two electrodes
b) melting a volume of material of said substrate by heating said volume using a heat source, said volume extending fully or partially from a first surface of said substrate to a second surface of said substrate, said second surface being opposite said first surface,
c) removing the molten volume of material resulting from step b) by applying a voltage across said substrate using two electrodes connected to a user-controlled voltage source and placed at a distance from and on opposite sides of said substrate, thereby applying a defined amount of electrical energy to the substrate and dissipating said electrical energy from said substrate,
wherein the rate of dissipating said applied electrical energy is controlled by at least one current and/or power modulating element, said at least one current and/or power modulating element being part of the electrical connection between said voltage source and said electrodes,
wherein said current and/or power modulating element is a resistor, a capacitor or an inductor or any combination of the foregoing, with the proviso that, if there is only one current and/or power modulating element, it is not an ohmic resistor.

2. The method according to claim 1, wherein said method is performed using a device comprising
- a first electrode and a second electrode,
- a switch,
- optionally an AC voltage source,
- a DC voltage source,
- a timing and control unit,
- a means to hold a substrate, and
- a laser
said first electrode being a ground or reference electrode, said second electrode being a voltage electrode for applying a voltage to said substrate, said electrodes being located on opposite sides of said substrate, said second electrode being connected to said switch which switch is connected to said AC voltage source and said DC voltage source; said AC voltage source, said DC voltage source, and said switch being connected to said timing and control unit.

3. The method according to claim 2, wherein said at least one current and/or power modulating element is located in the electrical connection between said switch and said DC voltage source, or is located in the electrical connection between said second electrode and said switch, or is located in the electrical connection between said first electrode and ground, or is part of said DC voltage source, or is part of said switch or any combination of the foregoing if there is more than one current and/or power modulating element.

4. The method according to any of claims 2-3, wherein there is more than one current and/or power modulating element which is, independently, at each occurrence, selected from a resistor, capacitor and an inductor.

5. The method according to claim 4, wherein there is a combination of two current and power modulating elements, and said combination is a combination of a resistor and a capacitor, or is a combination of a resistor and an inductor, or is a combination of a capacitor and an inductor.

6. The method according to claim 4, wherein there is a combination of three or more current and/or power modulating elements, e.g. three, four, five or more, and said combination is a combination of zero, one or more resistor(s), zero, one or more capacitor(s) and zero, one or more inductor(s) .

7. The method according to any of the foregoing claims, wherein said heat source is a laser or is a heating element or heating plate, connected to said timing and control unit and being capable of heating a substrate at a defined position, if such substrate is held by said means to hold a substrate.

8. The method according to any of the foregoing claims, wherein said current and/or power modulating element, if it is a resistor, has a resistance in the range of from 0.01 Ohm to 1 MOhm,
and, if it is a capacitor, it has a capacitance in the range of from 0.1 pF to 100 nF, and, if it is an inductor, it has an inductance in the range of from 0.1 uH to 10 mH.

9. The method according to any of the forgoing claims where said current and/or power modulating element(s) is (are) used to define and/or control the shape and/or geometry of the hole or recess or well.

10. A device for performing the method according to any of the foregoing claims, said device being defined as in any of claims 2-8.
